# EUROPÄISCHE PATENTSCHRIFT

(11) **EP 3 350 267 B1**
(45) Veröffentlichungstag und Bekanntmachung des Hinweises auf die Patenterteilung: **17.06.2020**
(21) Anmeldenummer: 16785356.3
(22) Anmeldetag: 08.09.2016
(51) Int. Cl.: C09D 5/24, C09D 7/40, H01B 1/20, H01B 1/22, H01B 1/24, C09D 11/52

(54) **LEITFÄHIGE NANOKOMPOSITE**
CONDUCTIVE NANOCOMPOSITES
NANOCOMPOSITES CONDUCTEURS

(30) Priorität: 15.09.2015 DE 102015115549
(43) Veröffentlichungstag der Anmeldung: 25.07.2018
(73) Patentinhaber: Leibniz-Institut für Neue Materialien gemeinnützige GmbH, 66123 Saarbrücken (DE)
(72) Erfinder: REISER, Beate, 67655 Kaiserslautern (DE); KRAUS, Tobias, 66111 Saarbrücken (DE); GONZÁLEZ-GARCÍA, Lola, 66123 Saarbrücken (DE); MAURER, Johannes H.M., 71034 Böblingen (DE); KANELIDIS, Ioannis, 66111 Saarbrücken (DE)
(74) Vertreter: Patentanwälte Gierlich & Pischitzis Partnerschaft mbB
(86) Internationale Anmeldenummer: PCT/EP2016/071132
(87) Internationale Veröffentlichungsnummer: WO 2017/045989

(56) Entgegenhaltungen:
- DE-A1-102013 002 855
- US-A1- 2009 286 082
- US-A1- 2011 052 926
- HU ET AL.: JOURNAL OF NANOPHOTONICS, Bd. 4, 23. Februar 2010 (2010-02-23), XP040550964,
- CHEN A ET AL: "Fabrication of Ag/polypyrrole coaxial nanocables through common ions adsorption effect", SYNTHETIC METALS, ELSEVIER SEQUOIA, LAUSANNE, CH, Bd. 156, Nr. 2-4, 1. Februar 2006 (2006-02-01), Seiten 346-350, XP027940264, ISSN: 0379-6779 [gefunden am 2006-02-01]

## Beschreibung

Leitfähige Strukturen auf Oberflächen spielen in der Mikroelektronik eine große Rolle. Allerdings sind die Verfahren zur Herstellung und Strukturierung solcher Strukturen oft sehr aufwendig.

In den letzten Jahren wurden verstärkt Systeme untersucht, bei denen solche Strukturen durch Druckprozesse auf Oberflächen aufgebracht werden können. Solche Nassbeschichtungs-Prozesse sind deutlich vielseitiger einsetzbar als die häufig verwendeten Photolithographieverfahren.

Solche Prozesse erfordern leitfähige Tinten, welche häufig leitfähige Partikel, insbesondere Nanopartikel, enthalten.

Dazu werden Suspensionen, welche entsprechende Nanopartikel enthalten, verwendet. Nach Auftragen auf einer Oberfläche verdunstet das Lösungsmittel und die Partikel kommen in Kontakt und ermöglichen so eine leitfähige Beschichtung. Gerade bei Nanopartikeln müssen die Suspensionen allerdings noch zusätzlich Stabilisatoren enthalten, welche eine Aggregation der Nanopartikel verhindern. Diese bilden eine organische Beschichtung auf der Oberfläche der Nanopartikel. Diese ist häufig nicht leitend. Daher ist bei solchen Suspensionen eine Temperaturbehandlung nötig, um die Stabilisatoren von der Oberfläche der Nanopartikel zu entfernen.

Dies gilt auch, wenn die Partikel in Matrices, insbesondere Polymermatrices eingebracht werden. Sinterschritte beeinflussen auch das Matrixpolymer in ungewünschter Weise. Außerdem entstehen beim Entfernen der Liganden Lücken in der vorher gebildeten Matrixstruktur, so dass ggf. die Superstruktur kollabiert.

Auch wenn organische Lösungsmittel häufig niedrige Siedepunkte aufweisen, so sind schon aus Kostengründen Lösungsmittel wie Wasser, Alkohole oder Mischungen davon zu bevorzugen. Dies macht es aber erforderlich, dass die Suspensionen auch in diesen Lösungsmitteln stabil sind.

Kanehara et al. Angew. Chem. Int. Ed. 2008, 47, 307-310; Abe et al. Organic Electronics 2014, 15, 3465-3470; Minari et al. Adv. Funct. Mater. 2014, 24, 4886-4892 und US 2013/0001479 A1 beschreiben sphärische Nanopartikel, welche mit Phthalocyaninen modifiziert werden. Diese bilden leitfähige Liganden zur Bildung von leitfähigen Strukturen aus Tinten mit polaren Lösemiteln.

US 2007/0057255 A1 beschreibt mit Tetrazolen modifizierte Nanopartikel.

Englebienne et al. J. Coll. Interface Sci. 2005, 292, 445-454 und US 7,686,983 beschreiben eine Mischung aus einem leitfähigen Polymer und Nanopartikeln auf der Basis von Polyanilinderivaten für chemische Sensorik.

DE 10 2013 002 855 A1 offenbart Silbernanodrähte mit einer Länge von über 1 µm.

Hu et al. Journal of Nanophotonics 2010, 4, 041545 "Tunable multicolored hybrid metallic nanoparticles for live human cancer cell imaging" beschreibt die Anlagerung von leitfähigen Liganden als mehrlagige Schichten Nanopartikel als optische Proben.

Chen et al. Synthetic Metals 2006, 156(2-4), 346-350 "Fabrication of Ag/polypyrrole coaxial nanocables through common ions adsorption effect" untersucht den Einfluss von Silberionen auf eine Ppy-Beschichtung auf Silbernanodrähten.

US 2009/286082 A1 beschreibt die Einarbeitung von Nanodrähten in einer Monomerlösung mit nachträglicher Polymerisierung.

US 2011/052926 A1 beschreibt die nachträgliche Beschichtung von Nanodrähten.

### Aufgabe

Aufgabe der Erfindung ist es, eine Zusammensetzung anzugeben, welche eine einfache Herstellung von leitfähigen Strukturen auf Oberflächen ermöglicht. Außerdem soll ein Verfahren zur Herstellung solch einer Zusammensetzung und ein Verfahren zur Herstellung leitfähiger Strukturen mit solchen Zusammensetzungen angegeben werden.

### Lösung

Diese Aufgabe wird durch die Erfindungen mit den Merkmalen der unabhängigen Ansprüche gelöst. Vorteilhafte Weiterbildungen der Erfindungen sind in den Unteransprüchen gekennzeichnet. Der Wortlaut sämtlicher Ansprüche wird hiermit durch Bezugnahme zum Inhalt dieser Beschreibung gemacht. Die Erfindungen umfassen auch alle sinnvollen und insbesondere alle erwähnten Kombinationen von unabhängigen und/oder abhängigen Ansprüchen.

Die Aufgabe wird gelöst durch eine Zusammensetzung zur Herstellung von leitfähigen Schichten durch Nassbeschichten (=Tinte), umfassend
a) mindestens eine Art von leitfähigen oder halbleitfähigen Nanostrukturen, wobei auf der Oberfläche der Nanostrukturen mindestens ein leitfähiger Ligand angeordnet ist und die Nanostrukturen Nanodrähte mit einer Länge von unter 500 nm sind und der mindestens eine leitfähige Ligand ein Polymer oder Oligomer mit mindestens 10 Bindungsstellen aufweist, welche eine koordinative Bindung zur Oberflächen der Nanostruktur ermöglichen;
b) mindestens ein Lösungsmittel.

Die Nanostrukturen sind bevorzugt anorganische Nanostrukturen. Es kann sich um metallische Nanostrukturen handeln, welcher ein Metall, Mischungen aus zwei oder mehr Metallen oder eine Legierung aus zwei oder mehr Metallen umfassen. Bevorzugt sind die Metalle ausgewählt aus Gold, Silber, Kupfer, Platin, Palladium, Nickel, Ruthenium, Indium oder Rhodium. Die Nanostrukturen können auch leitfähige oder halbleitfähige Oxide umfassen. Beispiele für solche Oxide, welche auch dotiert sein können, sind Indium-Zinn-Oxid (ITO) oder Antimon-Zinn-Oxid (ATO). Es können auch Halbleiter der Gruppen II-VI, III-V oder IV oder Legierung solcher Halbleiter sein. Beispiele dafür sind CdS, CdSe, CdTe, InP, InAs, ZnS, ZnSe, ZnTe, HgTe, GaN, GaP, GaAs, GaSb, InSb, Si, Ge, AlAs, PbSe oder PbTe.

Bevorzugt sind metallische Nanostrukturen umfassend Gold, Silber, Kupfer, Platin, Palladium, Nickel, Ruthenium, Indium oder Rhodium, Mischungen oder Legierungen davon.

Es handelt sich um Nanostrukturen. Dies bedeutet, dass es sich um Strukturen handelt, welche in mindestens einer, bevorzugt in mindestens zwei, oder allen Dimensionen eine Ausdehnung von unter 200 nm aufweisen (gemessen mit TEM).Die Nanostrukturen können auch in verschiedene Dimensionen unterschiedliche Ausdehnungen aufweisen. Beispiele dafür sind Nanodrähte, welche ein Verhältnis der längsten Dimension zur jeder der beiden anderen Dimensionen von jeweils mindesten 1,5, bevorzugt mindestens 2 aufweisen. Nanodrähte haben den Vorteil, dass bei geeigneter Anordnung die Anzahl der Nanostruktur-Nanostruktur-Grenzflächen für die gleiche Fläche geringer ist, als bei der Verwendung von sphärischen Partikeln. Dies kann die Leitfähigkeit einer solchen Struktur verbessern.

Die Nanostrukturen sind Nanodrähte (NR: nanorods). Diese weisen bevorzugt ein Seitenverhältnis von Länge zu Durchmesser von mindestens 1,5:1 insbesondere mindestens 2:1, bevorzugt mindestens 3:1 auf. Das Seitenverhältnis ist bevorzugt unter 100:1, insbesondere unter 50:1.

Die Nanodrähte weisen eine Länge von unter 500 nm auf. Der Durchmesser liegt dabei bevorzugt bei unter 500 nm, bevorzugt bei unter 100 nm, insbesondere bei unter 50 nm, wobei sich die andere Dimension jeweils entsprechend des Seitenverhältnisses verhält.

Die Länge der Nanodrähte liegt davon unabhängig bevorzugt bei über 50 nm, insbesondere über 100 nm.

Auf der Oberfläche der Nanostrukturen ist mindestens ein leitfähiger Ligand angeordnet.

Der Ligand hat die in Schema 2 dargestellte Struktur. Es handelt sich um ein leitfähiges Polymer, dessen Polymerrückrat entweder durch sein konjugiertes pi-System oder durch eine Funktionalität direkt im oder in direkter Nachbarschaft zum leitfähigen Polymerrückrat an den Nanostrukturen adsorbiert. Um gesteigerte Stabilität zu gewährleisten handelt es sich um eine polymere oder oligomere Struktur, die mindestens 10 Bindungsstellen aufweist. Diese Bindungsstellen ermöglichen eine koordinative Bindung zur Oberfläche der Nanostruktur, bevorzugt sind sie daran gebunden. Weiterhin ist der Ligand dadurch gekennzeichnet, dass er mindestens eine Seitenkette, die nicht zum konjugierten pi-System gehört, aufweist. Durch geeignete Wahl dieser Seitenkette(n): polare Gruppen zur Gewährleistung von kolloidaler Stabilität in polaren Lösemitteln und sterisch anspruchsvolle unpolare Seitenketten zur Gewährleistung von kolloidaler Stabilität in unpolaren Lösemitteln. Die Seitenkette kann auch so gewählt sein, dass sie eine weitere Verbindung wie z.B. ein weiteres Polymer bindet, welches die geeigneten funktionellen Gruppen trägt.

Unter Bindungsstelle wird die Ausbildung einer mindestens koordinativen Bindung zur Oberfläche der Nanostruktur verstanden. Diese erfolgt bevorzugt über Heteroatome wie O, N, Se oder S, insbesondere S. Schwefel ist gerade bei metallischen Oberflächen die bevorzugte Bindungsstelle.

Der leitfähige Ligand umfasst daher bevorzugt ein leitfähiges Polymer. Dies sind Polymere mit einem konjugierten pi-System als Rückgrat.

Solche leitfähigen Polymere sind beispielsweise Polymere auf Basis von Pyrrol wie Polypyrrol, Poly(N-substituiertes Pyrrol), Poly(3-substituiertes Pyrrol) und Poly(3,4-substituiertes Pyrrol); Thiophen wie Polythiophen, Poly(3-substituiertes Tiophen), Poly(3,4-substituiertes Thiophen), Polybenzothiophen, Polyisothionaphthen, Polyfurane, Polybenzofurane, Polycarbazole, Polyselenophene, Polyindole, Polypyridazine, Polyaniline, Polymethoxyphenylene. Die Polymere können auch Copolymere oder Block-Copolymere mit anderen Monomeren sein.

Bevorzugte Polymere sind Polythiophene, Polypyrrole außer Poly(N-substituiertes Pyrrol), Polyfurane, Polybenzofurane, Polybenzothiophene, Polycarbazole, bevorzugt Polythiophene wie Polythiophen, Poly(3-substituiertes Thiophen), Poly(3,4-substituiertes Thiophen), sowie Polybenzothiophen. Bei diesen Polymeren bilden die Heteroatome der Monomere die Bindungsstellen zur Oberfläche der Nanostruktur. Bei mindestens 10 Bindungsstellen, weist das Polymer oder Oligomer mindestens 10 Monomereinheiten auf. Bevorzugt sind Liganden mit mindestens 50, insbesondere mindestens 100 Bindungsstellen. Bevorzugt ist davon unabhängig, dass der Ligand nicht mehr als 2000, insbesondere nicht mehr als 1500 Bindungsstellen aufweist. Bevorzugt entspricht eine Bindungsstelle einem Monomer eines Polymers und/oder Oligomers.

Beispiele für weitere Monomere falls der Ligand weitere Monomere umfasst sind beispielsweise Styrolsulfonsäure oder Polystyrolsulfonsäure.
Beispiele für Thiophene sind Ethylen-3,4-dioxythiophen, 2-(3-thienyl)ethoxy-4-butylsulfonat (z. B. als Natriumsalz), 3-Hexylthiophen, bzw. die entsprechenden Polythiophene Poly(ethylen-3,4-dioxythiophen), Poly(2-(3-thienyl)ethoxy-4-butylsulfonat), und Poly(3-hexylthiophen.

Die Seitenkette des Liganden kann beispielsweise mindestens eine polare Gruppe aufweisen, welche die Kompatibilität mit polaren Lösungsmitteln erhöhen. Beispiele für solche Gruppen sind Aminogruppen, Hydroxylgruppen, Carboxylgruppen, Estergruppen, Halogene, Thiole, Ethergruppen, Thioethergruppen, Sulfatgruppen, Sulfonsäuregruppen, Amidgruppen, Nitrogruppen, Cyanogruppen, und Phosphonatgruppen. Die Seitenkette ist bevorzugt eine aliphatische verzweigte oder unverzweigte Kohlenstoffkette umfassend 4 bis 25 Kohlenstoffatome, wobei ein oder mehrere nicht benachbarte CH₂-Gruppen durch O, NR oder S substituiert sein können, wobei R für Wasserstoff oder einen aliphatischen Rest mit 1 bis 10 Kohlenstoffatomen steht, welche die mindestens eine polare Gruppe als Substituenten umfasst.
Der Ligand kann auch mehr als eine polare Gruppe umfassen. Bevorzugt sind mindestens 5 polare Gruppen pro Ligand.

Bevorzugt ist mindestens eine funktionale Gruppe pro Ligand. Bevorzugt ist, dass solche Gruppen vorhanden sind, dass der Ligand in einem pH-Bereich zwischen 4 und 10 eine Nettoladung aufweist. Es kann sich auch um mindestens eine funktionale Gruppe pro Monomer handeln.
Die Seitenkette des Liganden kann auch mindestens eine unpolare Gruppe aufweisen, welche die Kompatibilität mit unpolaren/hydrophoben Lösungsmitteln erhöht. Beispiele hierfür sind aliphatische oder cycloaliphatische Kohlenwasserstoffketten mit 4 bis 25 Kohlenstoffatomen und/oder aromatische Gruppen mit 6 bis 20 Kohlenstoffatomen. Es können auch Heteroatome wie z.B. Silanstrukturen vorhanden sein.
Beispiele für solche Gruppen sind Alkylgruppen wie Butyl, Pentyl, Hexyl, Heptyl, Oktyl, Nonyl, Decyl, Undekyl, Dodecyl unverzweigte Gruppen oder als Konstitutionsisomere mit gleicher Anzahl von Kohlenstoffen. Beispiele für cycloaliphatische Gruppen sind Cyclohexyl, Cycloheptyl. Beispiele für aromatische Gruppen sind Phenyl, Naphthyl, Anthracyl, und Peryl. Die Seitenkette kann auch mehrere dieser Gruppen umfassen.
Der Ligand kann auch Seitenketten mit polaren Gruppen und Seitenketten mit unpolaren Gruppen umfassen. Es können auch mehrere unterschiedliche polare oder unpolare Gruppen vorhanden sein.
Die Seitenkette kann auch so gewählt sein, dass sie eine weitere Verbindung wie z.B. ein weiteres Polymer bindet, welches die geeigneten funktionellen Gruppen trägt.

Die Zusammensetzung kann auch noch mindestens ein weiteres Polymer umfassen, welches an den Liganden bindet und eine entsprechende Seitenkette trägt.

So können sich beispielsweise Polymere mit aromatischen Gruppen, wie z. B. Polystyrole, an das pi-System des leitfähigen Polymers oder Oligomers anlagern. Auch Polymere mit unterschiedlichen Ladungen können verwendet werden. So können geladene Polymere mit dem leitfähigen Liganden wechselwirken, wenn dieser eine entgegengesetzte Ladung tragen kann. Diese kann auch temporär vorliegen.

In diesem Fall trägt dieses weitere Oligomer mindestens eine entsprechende Seitenkette wie vorstehend beschrieben, insbesondere zur Herstellung der Löslichkeit in einem Lösungsmittel.

Bevorzugt ist eine Kombination aus einem substituierten oder unsubstituierten Thiophen als Ligand und einem Polystyrol mit mindestens einer polaren Seitengruppe, insbesondere geladenen, wie beispielsweise Polymere oder Oligomere aus Styrolsulfonsäure (PSS).

Die Zusammensetzung umfasst dann neben dem Liganden mindestens ein weitere Polymer oder Oligomer, welche mit dem Liganden wechselwirkt und damit die Löslichkeit des Liganden in der Zusammensetzung begünstigt. Der Ligand und das mindestens eine weitere Polymer können in unterschiedlichem Gewichtsverhältnis vorliegen, beispielsweise zwischen 5:1 und 1:5 oder 2:1 und 1:2, insbesondere 1,5:1 und 1:1,5.

Eine bevorzugte Kombination ist Poly(ethylen-3,4-dioxythiophen) (PEDOT) mit Polystyrolsulfonsäure (PSS).

Der Ligand ist bevorzugt ein Polymer oder Oligomer mit einer mittlere molekularen Masse von mindestens 5 kDa, bevorzugt nicht mehr als 1000 kDa (gemessen mit Gel-Permeations-Chromatographie), bevorzugt von mindestens 10 kDa bis 500 kDa, insbesondere von 30 kDa bis 100 kDa.

In einer bevorzugten Ausführungsform der Erfindung umfasst die Zusammensetzung mindestens ein Matrixpolymer. Dieses kann ein leitfähiges oder nicht leitfähiges Polymer sein, bevorzugt ist es ein nicht leitfähiges Polymer. Leitfähige Polymere sind vorstehend bereits definiert.

Das Matrixpolymer liegt bevorzugt gelöst in der Zusammensetzung vor. Dazu kann es erforderlich sein, ein geeignetes Lösungsmittel zu wählen.

Bevorzugte Matrixpolymere sind gängige lösliche Kunststoffe wie Polystyrol, Polyacrylate wie Polymethylmethacrylat, Polyvinylalkohol oder Polyvinylpyrrolidon oder Mischungen davon.

Der Anteil der Nanostrukturen liegt bevorzugt bei mindestens 10 Gew.-%, insbesondere bei mindestens 30 Gew.-%, bezogen auf die Zusammensetzung ohne Lösungsmittel. Der Anteil der Nanostrukturen kann bei bis zu 90 Gew.-% liegen. Bevorzugte Anteile liegen bei 10 Gew.-% bis 90 Gew.-%, insbesondere 20 Gew.-% bis 80 Gew.-%, ganz besonders bei 30 Gew.-% bis 70 Gew.-%.

Die Kombination aus leitfähigem Ligand und Nanostruktur wird auch als Typ I-Komposit bezeichnet. Wenn zusätzlich ein Matrixpolymer vorhanden ist, wird dies im Folgenden als Typ II-Komposit bezeichnet.

Durch die Verwendung von leitfähigem Ligand kann erreicht werden, dass die Probleme, welche durch die bisherige notwendige Entfernung der Liganden entstehen vermieden werden. So wird es möglich Komposite vom Typ II in einem Prozessschritt aus einer Tinte mit geeigneter Zusammensetzung herzustellen. Normalerweise beeinflusst der Sinterschritte auch das Matrixpolymer in ungewünschter Weise, da aber durch die Erfindungsgemäßen Liganden kein Sinterschritt nötig ist, wird dieses Problem durch die Erfindung gelöst. Außerdem besteht durch die Verwendung von Erfindungsgemäßen Liganden nicht mehr die Gefahr, dass beim Entfernen von sterisch anspruchsvollen Ligandenhüllen Lücken in der zuvor gebildeten Struktur entstehen, sodass ggf. die Superstruktur kollabiert.
Bevorzugte Zusammensetzungen Typ II benötigen keinen separaten Sinterschritt, üblicherweise bei Temperaturen von über 100 °C. Das Lösungsmittel ist bevorzugt ausgewählt aus Lösungsmitteln oder Lösungsmittelgemischen aus Lösungsmittel mit jeweils einem Siedepunkt von unter 120 °C. Solche Lösungsmittel erlauben es, dass das Lösungsmittel bei niedrigen Temperaturen, beispielsweise von unter 60 °C, schnell entfernt werden kann.
Das Lösungsmittel ist bevorzugt ein flüchtiges Lösungsmittel, insbesondere ein bei Raumtemperatur flüchtiges Lösungsmittel. Beispiele für solche Lösungsmittel sind Wasser, Alkohole, Ketone oder Ether, sowie Mischungen davon. Es können weitere Lösungsmittel enthalten sein.

Das weitere Lösungsmittel kann beispielsweise ausgewählt sein aus Alkanen, Aromaten und Heteroaromaten, Cyclische Aromaten, Ester, Ketonen, Amiden, und Sulfonaten.

Das Lösungsmittel kann mindestens einen Alkohol umfassen. Der mindestens eine Alkohol ist bevorzugt ein Alkohol mit bis zu 10 Kohlenstoffatomen. Beispiele für solche Alkohole sind Methanol, Ethanol, n-Propanol, Isopropanol, n-Butanol, i-Butanol, 2-Butanol, tert.-Butanol, 1-Pentanol, 2-Methyl-1-butanol, 3-Methyl-1-butanol, Hexanol, Heptanol, Octanol, 1-Octanol, 1-Nonanol, 1-Dekanol, Allylalkohol, Crotylalkohol, Proparylalkohol, Cyclopentanol, Cyclohexanol, 2-Methoxyethanol, 2-Ethoxyethanol, 2-Butoxyethanol, Ethylenglykol, und Propylenglykol.

Beispiele für Ketone sind Aceton, Methylethylketon, und Methylisobutylketon.
Beispiele für Ester sind Ethylacetat, Methylacetat, Propylacetat, Butylacetat, Ethylbutyrat, Methylbutyrat, Ethylpropionat, Methylpropionat, und Propylpropionat. Beispiele für Alkane sind Pentan, Hexan, Heptan, Oktan, Nonan und deren Konstitutionsisomere sowie entsprechende cyclische Verbindungen mit gleicher Anzahl an Kohlenstoffen wie Cyclohexan.
Für Typ I Komposite ist das Lösungsmittel bevorzugt ausgewählt aus Wasser, Alkohol oder Gemischen umfassend Wasser und/oder mindestens einen Alkohol.
Typ II Komposite setzen voraus, dass das Matrixpolymer auch im gegebenen Lösemittel in ausreichender Menge löslich ist. So ist bevorzugt ein Lösemittel zu wählen, in dem gängige Polymere wie z.B. Polystyrol, Polymethylmethacrylat, Polyvinylalkohol oder Polyvinylpyrrolidon löslich sind. Beispiele hierfür sind Aceton, Cyclohexan und Wasser, sowie Gemische davon.

Die Wahl des Lösungsmittels bestimmt auch die kolloidale Stabilität der Dispersion. Diese kann durch passende funktionale Gruppen auf der Oberfläche der Nanostrukturen, beispielsweise eingeführt durch Liganden, beeinflusst werden.

In polaren Lösemitteln ist der Betrag des Zetapotentials der Nanostruktur in der Zusammensetzung im pH Bereich von 5-9 bevorzugt größer als 5 mV.

Der Gehalt an Ligand zu Nanostruktur ist bevorzugt so gewählt, dass die maximale Dicke der Ligandenhülle auf der Oberfläche der Nanostruktur bei unter 5 nm, insbesondere bei unter 2 nm liegt (bestimmt mit TEM).

Bevorzugt liegt der Belegungsgrad der Nanostruktur mit Ligand bei mindestens 1 Monolage auf der gesamten Partikeloberfläche, aber bei weniger als 10 Lagen Ligand, welche die Partikeloberfläche ummantelt. Bei konjugierten Polymeren ist unabhängig vom Mw eine Belegung von mindestens 1 aber maximal 50 Monomereinheiten pro nm² Partikeloberfläche bevorzugt. Insbesondere ist eine Belegung von mindestens 2 aber maximal 20 Monomereinheiten pro nm² Partikeloberfläche bevorzugt. Diese Angaben können aus TEM-Messungen in Kombination mit gravimetrischer Bestimmung des organischen Anteils berechnet werden.

Durch geeignete Wahl der Gruppen des Liganden und die dadurch einstellbare Löslichkeit, ist es außerdem möglich zwei Lagen übereinanderzuschichten und dabei die Lösemittel "orthogonal" zu wählen, sodass die darunterliegende Schicht nicht durch das Lösemittel der neuen Tinte aufgelöst wird (z.B. bei "solution processed" Solar cells im "layer-by-layer" approach).

Die Komponente a) der erfindungsgemäßen Zusammensetzung kann auf unterschiedliche Weise erhalten werden. So kann der leitfähige Ligand bereits bei der Herstellung der Nanostrukturen, beispielsweise durch Ausfällung oder Reduktion, eingesetzt werden.

Der leitfähige Ligand kann auch durch Ligandentausch eingeführt werden. Dazu wird bevorzugt ein Verfahren umfassend folgende Schritte durchgeführt:
a) Bereitstellen einer Dispersion von leitfähigen oder halbleitfähigen Nanostrukturen, wobei die Dispersion durch mindestens einen ersten Liganden stabilisiert wird;
b) Zugabe mindestens eines leitfähigen Liganden;
c) Austausch mindestens eines Teils des ersten Ligands
durch den mindestens einen leitfähigen Ligand;

Im Folgenden werden einzelne Verfahrensschritte näher beschrieben. Die Schritte müssen nicht notwendigerweise in der angegebenen Reihenfolge durchgeführt werden, und das zu schildernde Verfahren kann auch weitere, nicht genannte Schritte aufweisen.

Bei diesem Verfahren wird eine Nanostruktur mit leitfähigem Liganden auf der Oberfläche hergestellt oder Nanostruktur, deren auf der Oberfläche befindlicher, nicht leitfähiger Ligand gegen einen leitfähigen Liganden ausgetauscht wird. Dabei darf es nicht zur Beeinträchtigung der kolloidalen Stabilität der Dispersion kommen. Sonst kommt es zu einer Aggregation der Nanopartikel.

Im Fall des Ligandentauschs wird zunächst eine Dispersion von leitfähigen oder halbleitfähigen Nanostrukturen bereitgestellt, welche durch mindestens einen ersten Liganden stabilisiert wird. Als Nanostrukturen eignen sich die für die Zusammensetzungen beschriebenen.

Die Dispersion wird durch mindestens einen ersten Liganden stabilisiert. Dies bedeutet, dass die Dispersion unter den Bedingungen des Ligandenaustauschs stabil bleibt. So kann beispielsweise die Konzentration an Überschuss dieses Liganden bei über 20 µM liegen, aber unter 10 mM, bevorzugt ist eine Konzentration zwischen 30 µM bis 1 mM, insbesondere zwischen 50 µm bis 800 µM.

Der mindestens eine erste Ligand umfasst dabei bevorzugt mindestens eine Gruppe zur Koordination mit der Oberfläche der Nanostruktur. Dadurch kann er die erforderliche Oberflächenschicht bilden, welche eine Aggregation der Strukturen verhindert. Der Ligand ist bevorzugt nicht kovalent gebunden, wie z. B. Thiole auf Goldoberflächen.

Beispiele für solche Liganden sind Liganden umfassend Karbonsäuregruppen, Ammoniumgruppen wie Tetraalkylammoniumgruppen, Aminogruppen handeln. Beispiele für solche ersten Liganden sind Citrate oder Cetyltrimethylammoniumbromid (CTAB).

Es kann erforderlich sein, einen möglichen Überschuss an erstem Ligand zu entfernen. Dies kann beispielsweise durch Zentrifugation und Redispergierung geschehen. Wichtig ist, dass dabei die kolloidale Stabilität noch gegeben ist.

Um Aggregation zu vermeiden, kann es von Vorteil sein, die Konzentration der Nanostrukturen gering einzustellen. Bevorzugt ist eine Konzentration von unter 10 mg/mL, insbesondere unter 4 mg/mL, ganz besonders unter 1 mg/mL.

Um eine ausreichende Bedeckung der Oberfläche der Nanostrukturen und damit auch eine ausreichende kolloidale Stabilität zu gewährleisten, wird der mindestens eine leitfähige Ligand bevorzugt in einer Konzentration von mindestens 0,5 µg Polymer je cm² Partikeloberfläche eingesetzt. Die Fläche wird mittels DLS- oder TEM-Messungen bestimmt. Die Aggregation der Partikel in der Dispersion geschieht insbesondere erst beim Entfernen des Lösungsmittel. Erfindungsgemäße Zusammensetzungen sind bevorzugt mindestens 24 Stunden, insbesondere mindestens 1 Woche, ganz besonders mindestens 1 Monat, stabil, d.h. dass keine Aggregation mit UVvis festgestellt werden kann.

Die Nanostrukturen werden bevorzugt mindestens 1 Stunde, besonders bevorzugt mindestens 5 Stunden, mit dem mindestens einen leitfähigen Liganden inkubiert. Bevorzugt sind mindestens 12 Stunden. Es kann sich um 5 Stunden bis 100 Stunden, insbesondere 12 bis 36 Stunden handeln.

Dabei wird mindestens ein Teil des ersten Liganden durch den mindestens einen leitfähigen Liganden ausgetauscht, bevorzugt ist ein vollständiger Austausch.

Nach erfolgtem Austausch kann es erforderlich sein, nicht adsorbierte Liganden zu entfernen. Dazu kann die Dispersion durch Zentrifugation und Verwerfen des Überstands gereinigt und aufkonzentriert werden. Weiterhin kann in diesem Schritt das Lösemittel für die Zusammensetzung der Tinte gewählt werden. Dabei sollte es nicht zu einem Eintrocknen der Dispersion kommen. Bevorzugt bleiben die mit dem Liganden modifizierten Partikel immer mit Lösungsmittel benetzt.

Die Erfindung betrifft auch ein Verfahren zur Herstellung einer leitfähigen oder halbleitfähigen Schicht auf einer Oberfläche umfassend folgende Schritte:
a) Aufbringen einer erfindungsgemäßen Zusammensetzung auf eine Oberfläche;
b) Entfernung des mindestens einen Lösungsmittels.

Im Folgenden werden einzelne Verfahrensschritte näher beschrieben. Die Schritte müssen nicht notwendigerweise in der angegebenen Reihenfolge durchgeführt werden, und das zu schildernde Verfahren kann auch weitere, nicht genannte Schritte aufweisen.

In einem ersten Schritt wird die erfindungsgemäße Zusammensetzung auf eine Oberfläche aufgebracht. Dies kann durch alle dem Fachmann bekannten Verfahren zur Nassbeschichtung gestehen. Dies kann beispielweise durch Inkjet-Druck, Sprühen, Tauchen, Fluten, Spritzen, Schleudern, Rakeln geschehen. Entsprechend der Art des Auftragens kann die erforderliche Konzentration der Dispersion, das Lösungsmittel, sowie mögliche Additive gewählt werden. Entsprechend kann auch die Viskosität angepasst werden.

Als Lösungsmittel sind die Lösungsmittel wie für die Zusammensetzung beschrieben bevorzugt.

Das Material der Oberfläche sollte kompatibel zur verwendeten Zusammensetzung, insbesondere des Lösungsmittels sein. Aufgrund der niedrigen Temperaturen kann das Material der Oberfläche frei gewählt werden. Es kann sich um eine organische oder anorganische Oberfläche handeln. Sie kann beispielsweise Kunststoffe, Metalle, Halbmetalle, Glas oder Keramik umfassen.

In einer bevorzugten Ausführungsform der Erfindung findet die Entfernung des mindestens einen Lösungsmittels bei einer Temperatur von unter 60 °C, insbesondere unter 40 °C statt. Bevorzugt sind Temperaturen zwischen 4 °C und 30 °C.

Es kann auch Unterdruck angewendet werden, insbesondere unter 1 bar.

Durch die Verwendung eines leitfähigen Liganden ist eine Entfernung dieses Liganden zur Herstellung der Leitfähigkeit der Beschichtung nicht erforderlich. Durch den Ligand ist ein Austausch von Elektronen zwischen den Partikeln einfach möglich.

Dadurch können die im Stand der Technik notwendigen zusätzlichen thermischen Behandlungen zur Entfernung der Ligandenhülle vermieden werden. Wenn die Entfernung der Ligandenhülle nicht nötig ist, entstehen außerdem folgende Vorteile:
- Ein energieaufwändiger Prozessschritt entfällt;
- Eine Entfernung eines Liganden mit gegebenem Volumen führt notwendigerweise zu einer Verkleinerung des Raumbedarfs eines Partikels um das gegebene Volumen. Dies kann gegebenenfalls dazu führen, dass eine zuvor aufgebaute Struktur zusammenbricht, oder wenn es sich um eine Monolage an Partikeln handelt: dass der direkte Kontakt zwischen den Partikeln verloren geht.
- Komposite vom Typ II können direkt in einem Prozessschritt durch Nassbeschichtung erzeugt werden und bei der Auswahl des Matrixpolymers muss nicht darauf geachtet werden, dass eine Entfernung des Liganden nicht auch das Matrixpolymer entfernt oder dessen Eigenschaften negativ beeinträchtigt.

In einer bevorzugten Ausführungsform umfasst das Verfahren nach dem Auftragen auf die Oberfläche keine Behandlung der Beschichtung bei Temperaturen von über 60 °C, insbesondere von über 40 °C.

Die Erfindung betrifft außerdem leitfähige oder halbleitfähige Strukturen erhalten mit dem erfindungsgemäßen Verfahren.

Die Erfindung betrifft außerdem ein Kompositmaterial umfassend eine leitfähige oder halbleitfähige Nanostruktur, mindestens einen leitfähigen Liganden und mindestens ein Matrixpolymer bevorzugt erhalten aus einer erfindungsgemäßen Zusammensetzung oder eines erfindungsgemäßen Verfahrens.

Die erfindungsgemäße Struktur oder das Kompositmaterial können vielseitig eingesetzt werden. Beispielsweise bei Displays, Leiterbahnen, Schaltkreisen, Kondensatoren, Solarzellen.

Weitere Einzelheiten und Merkmale ergeben sich aus der nachfolgenden Beschreibung von bevorzugten Ausführungsbeispielen in Verbindung mit den Unteransprüchen. Hierbei können die jeweiligen Merkmale für sich alleine oder zu mehreren in Kombination miteinander verwirklicht sein. Die Möglichkeiten, die Aufgabe zu lösen, sind nicht auf die Ausführungsbeispiele beschränkt. So umfassen beispielsweise Bereichsangaben stets alle - nicht genannten - Zwischenwerte und alle denkbaren Teilintervalle.

### 1. Herstellung der Goldnanodrähte mit CTAB

Goldnanodrähte mit Aspektverhältnissen von 20-50 nm Durchmesser und 80-150 nm Länge wurden mit einem Protokoll nach Ye et al. hergestellt. Dazu wurde eine Wachstumslösung (500 mL - 2 L) mit AuCl₄ (0,5 mM), Cetyltrimethylammoniumbromid (CTAB 0,4 M), Natriumoleat (800 mM), Ascorbinsäure (0,16 mM), mit unterschiedlichen Volumen an Silbernitratlösung (4 mM) und HCl (32 %) hergestellt. Anisotropes Kristallwachstum wurde durch Zugabe eines bestimmten Volumens an sphärischen Goldkeimen ausgelöst. Diese Keimdispersion wurde vorher durch Reduktion von 5 mL HAuCl₄ (0,25 mM) in wässriger CTAB-Lösung (0,1 M) mit NaBH₄ und Inkubation für 30 Minuten hergestellt. Die Reaktion wurde für 14 Stunden bei 35 °C ruhen gelassen. Die Goldnanodrähte (AuNR) wurden danach durch Zentrifugation gereinigt und in einer CTAB-Lösung (1 mM) aufbewahrt. Das Verfahren konnte bis zu einer Größe von 2 L skaliert werden, was einer Trockenmasse an Goldnanodrähten von ca. 200 mg Gold + zusätzliche Ligandenmasse (entspräche 210 mg) entspricht. Die hergestellten Goldnanodrähte weisen eine Abweichung in Durchmesser und Länge von unter 10 % bezogen auf den Durchschnitt (gemessen mit TEM) auf. Für Dispersionen wurde ein Zetapotential von +20 mV bei pH 7 gemessen. Dies deutet auf eine mittlere kolloidale Stabilität in Bezug auf rein elektrostatische Stabilisierung hin. Das Ligand/Metallverhältnis wurde thermogravimetrisch mit ungefähr 5:95 (m/m) bestimmt. Ausgehend von einer zylindrischen Form mit 20 nm Durchmesser und 100 nm Länge (bestimmt durch TEM), entspricht dies einer Monolage von 8 CTAB-Molekülen pro nm². CTAB neigt in wässriger Umgebung zur Bildung von Doppelschichten. Es wird angenommen, dass die Monolage auf den Golddrähten 4 oder weniger Moleküle CTAB pro nm² aufweist.

### 2. Ligandenaustausch

Die unter Punkt 1 hergestellten Goldnanodrähte stabilisiert mit CTAB (AuNR@CTAB) wurden gewaschen, um den Überschuss an CTAB zu entfernen und um den gewünschten Goldgehalt einzustellen. Dazu wurde eine Lösung des Polymers (0,5 mg/mL Poly(2-(3-thienyl)ethoxy-4-butylsulfonat (PTEBS) 40-70 kDa) in Wasser) gegeben und mit der Dispersion von AuNR@CTAB (0,5 mg/mL Gold in Wasser) und für 24 Stunden bei Raumtemperatur gerührt. Die Goldnanodrähte wurden durch Redispergieren in einem bestimmten Volumen reinen Lösungsmittels gereinigt und auf eine gewünschte Zielkonzentration gebracht. Das Zetapotential änderte sich von +20 mV auf -45 mV (pH 7), was auf einen erfolgreichen Austausch der Liganden hindeutet. Durch spektroskopische Methoden wurde ein erfolgreicher Ligandentausch bestätigt. Aus TEM Aufnahmen kann die Dicke der Ligandenhülle auf etwa 1 nm abgeschätzt werden, was im Einklang mit thermogravimetrischen Messungen ist. Aus Literaturdaten, die jeweils Aussagen über die Ausdehnung in eine der 3 Dimensionen machen (Liu et al. (Abstand der Monomere im Polythiophenrückrat), Zhang et al. (Abstand, den Polymerketten mit dieser Seitenkette bevorzugt zueinander einnehmen), Colle et al. (p-stacking Distanz zw. konjugierten Polymeren).) konnte eine Packungsdichte des Polymers von 7,2 Monomeren/nm³ für das verwendete Polymer berechnet werden und aus dem Massenverlust beim Aufheizen wurde ebenfalls die Dicke der Ligandenhülle zu 1 nm bestimmt.
Für kristalline Goldnanodrähte mit 23 nm x 103 nm Ausmaße wurde ein Massenverlust von 3,2 Gew.-% festgestellt. Bei Goldnanodrähten mit kleinerem Oberfläche/Volumen-Verhältnis (25 nm x 113 nm) wurden 2,9 Gew.-% Massenverlust berechnet. Wird das Verhältnis Ligandenmasse/Oberfläche-verwendet, so erhält man einen Wert von 3,4 mg/m² Partikeloberfläche für den Liganden aus 2.

Die kolloidale Stabilität in geeigneten Lösemitteln, Lösemittelgemischen und Lösemittel-Polymermischungen wurde demonstriert durch UVvis Spektroskopie.

### 2.1. Ligand mit zusätzlichem Polymer

Analog zu 2. wurde ein Ligandenaustausch mit PEDOT:PSS (Poly(ethylen-3,4-dioxythiophen):Polystyrolsulfonat) durchgeführt. Der Austausch der Liganden wurde mit Analysen bestätigt. Die erhaltenen Dispersionen waren in polaren Lösungsmitteln (Isopropanol, Aceton, Methanol, Ethanol) mindestens eine Woche stabil. Hergestellte Beschichtungen zeigen eine Leitfähigkeit von 1 Ω/sq, welche sogar besser ist als die Leitfähigkeit einer Nanostruktur nach Entfernung des Liganden.

### 2.2. Ligand für unpolare Lösungsmittel

Es wurden mit Poly(3-hexylthiophen-2,5-diyl, MN 15000-45000) modifizierte Goldnanodrähte hergestellt. Dazu wurde der Ligand während der Synthese zugegeben. Dieser Ligand begünstigt die Stabilität in unpolaren Lösungsmitteln (Chloroform, Toluol). Die Leitfähigkeit der hergestellten Schichten ohne Sintern wurde gemessen.

### 2.3. Austausch auf Goldnanopartikeln

Analog zu 2. wurde ein Ligandenaustausch mit Goldnanopartikeln (Durchmesser 15 nm, stabilisiert mit Citrat) durchgeführt. Das Zetapotential änderte sich von -29.2 mV auf 34.9 mV, was auf eine moderate Stabilität hindeutet.

### 3. Herstellung von Beschichtungen

Eine Dispersion in Wasser/Methanol (10:90) von erfindungsgemäß modifizierten Goldnanodrähten wurde auf ein Glassubstrat aufgetragen. Durch eine Form wurde eine gerade Linie erzeugt. Kommerziell erhältliche Silberfarbe wurde für die Elektroden verwendet.

Komposit Typ II: Eine Dispersion in Aceton/Wasser (97,5/2,5; v/v) von erfindungsgemäß modifizierten Goldnanodrähten mit gelöstem PMMA durch drop-casting auf eine Glasfläche (1x1 cm) aufgebracht und ein leitfähiger Komposit entsteht nach Eintrocknen des Lösemittels (40 °C, 5 Min.).

Die Ausführungsbeispiele sind in den Figuren schematisch dargestellt. Gleiche Bezugsziffern in den einzelnen Figuren bezeichnen dabei gleiche oder funktionsgleiche bzw. hinsichtlich ihrer Funktionen einander entsprechende Elemente. Im Einzelnen zeigt:
- Fig. 1: Schematische Darstellung einer erfindungsgemäßen Struktur; A: Nanostruktur; B: Leitfähiger Ligand; C: Luft oder Matrix;
- Fig. 2: Schematische Darstellung einer Ausführungsform des leitfähigen Liganden (B1: leitfähiges Polymerrückgrat; B2: Seitenkette kovalent an Polymerrückgrat gebunden);
- Fig. 3: a) TEM-Aufnahmen von Goldnanodrähten mit CTAB (AuNR@CTAB), Maßstabsbalken: oben: 400 nm; unten: 100 nm; b) TEM-Aufnahmen mit Goldnanodrähten mit erfindungsgemäßen Liganden, Maßstabsbalken: oben: 200 nm; unten: 50 nm;
- Fig. 4: UV-VIS-Spektren der Nanostrukturen und der Liganden, aufgetragen ist Wellenlänge (Wavelength) gegen Absorption (Absorbance) (A: reiner Ligand; B: Gold Nanostruktur mit CTAB als Liganden; C: Gold Nanostruktur mit erfindungsgemäßem Liganden);
- Fig. 5: IR-Spektren der Nanostrukturen und der Liganden, aufgetragen ist die Wellenzahl (wavenumber) gegen die Intensität (intensity)(A: reiner Ligand; B: Gold Nanostruktur mit CTAB als Liganden C: Gold Nanostruktur mit erfindungsgemäßem Liganden);
- Fig. 6: Raman-Spektren der Nanostrukturen jeweils bevor und nach dem Ligandentausch, aufgetragen ist die Ramanverschiebung (Raman shift)gegen die normalisierte Intensität (normalized intensity)(B: Gold Nanostruktur mit CTAB als Liganden C: Gold Nanostruktur mit erfindungsgemäßem Liganden);
- Fig. 7: Absorption von Dispersionen von AuNR@CTAB in verschiedenen Lösungsmitteln (A: Wasser; B: Wasser/Methanol (25/75; v/v); C: Wasser/Aceton (25/75; v/v), aufgetragen ist die Wellenlänge (Wavelength) gegen die Absorption (Absorbance);
- Fig. 8: Absorption von Dispersionen von Goldnanodrähten mit erfindungsgemäßen Liganden in verschiedenen Lösungsmitteln (A: Wasser; B: Wasser/Methanol (25/75; v/v); C: Wasser/Aceton (25/75; v/v), aufgetragen ist die Wellenlänge (Wavelength) gegen die Absorption (Absorbance) ;
- Fig. 9: Strom/Spannungsdiagramm für unterschiedliche Beschichtungen (C1: Goldnanodrähte modifiziert mit PEG-SH; C2: Goldnanodrähte modifiziert mit PEG-SH nach O₂-Plasmabehandlung (Widerstand R = 2,7 Ω); C3: Goldnanodrähte mit erfindungsgemäßen Liganden (Widerstand R = 11,5 Ω)), aufgetragen ist die Spannung (voltage) gegen den Strom (current);
- Fig. 10: SEM-Aufnahmen von hergestellten Beschichtungen ((a) Goldnanodrähte mit erfindungsgemäßen Liganden; (b) Goldnanodrähte modifiziert mit PEG-SH; (c) Goldnanodrähte modifiziert mit PEG-SH nach O₂-Plasmabehandlung;
- Fig. 11: SEM-Aufnahmen von Kompositen;

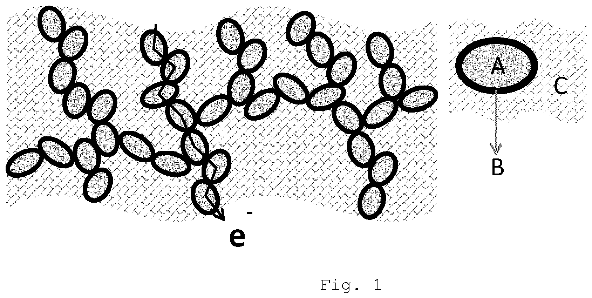

Figur 1 zeigt eine schematische Darstellung der erfindungsgemäßen Zusammensetzung mit Nanodrähten. Auf der Oberfläche (Typ I) oder in einer Matrix (Typ II) lagern sich die Nanodrähte so aneinander an, dass sie eine leitfähige lineare Struktur bilden. Durch die deutlich geringere Anzahl an Grenzflächen entlang dieser Struktur ist die Leitfähigkeit erhöht.

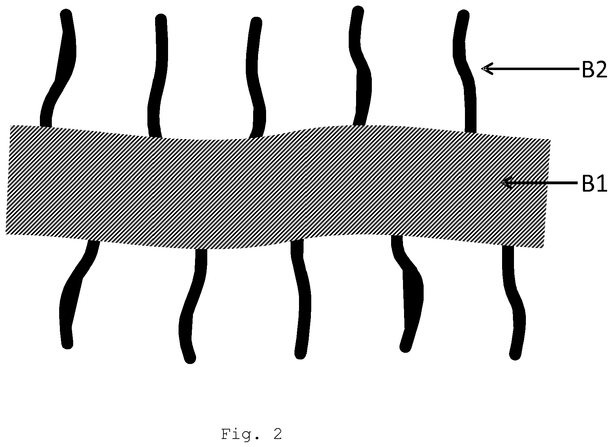

Figur 2 zeigt eine schematische Darstellung eines erfindungsgemäßen Liganden mit Polymerrückgrat und Seitenketten.

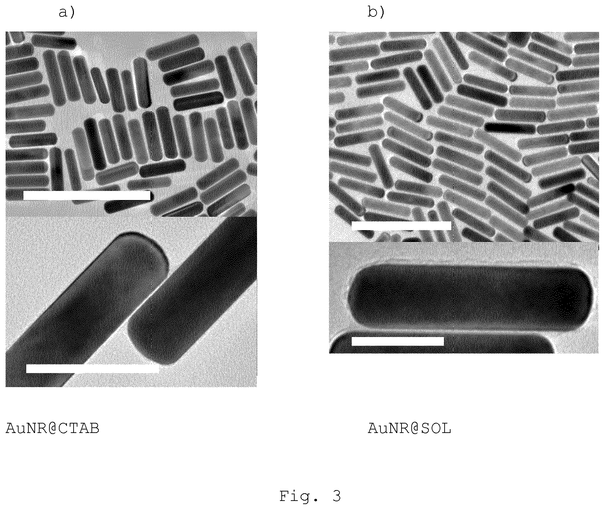

Figur 3 zeigt, dass bei dem Austausch der Liganden die Struktur der Goldnanodrähte und der Ligandenhülle erhalten bleibt.

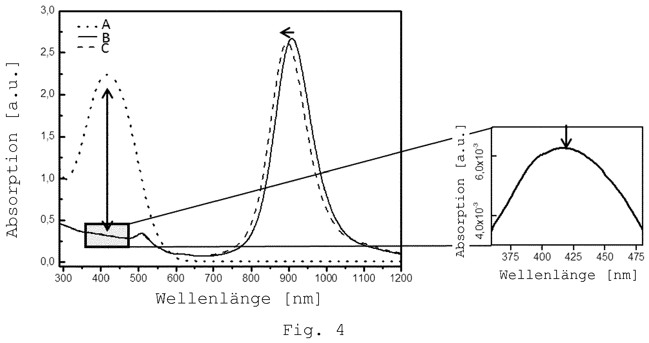

Figur 4 zeigt UV-VIS-Spektren in Wasser der Partikel mit CTAB (B), dem reinen Liganden (A) und Goldnanodrähten mit erfindungsgemäßen Liganden (C). Es zeigt sich, dass der Austausch der Liganden das Absorptionsmaximum bei 900 nm leicht verschiebt. Das kleinere Diagramm zeigt einen Ausschnitt aus der Substraktion der Spektren der beiden modifizierten Nanostrukturen (C-B). Aus der Substraktion ist das Maximum des Liganden bei 410 nm dann deutlich zu erkennen.

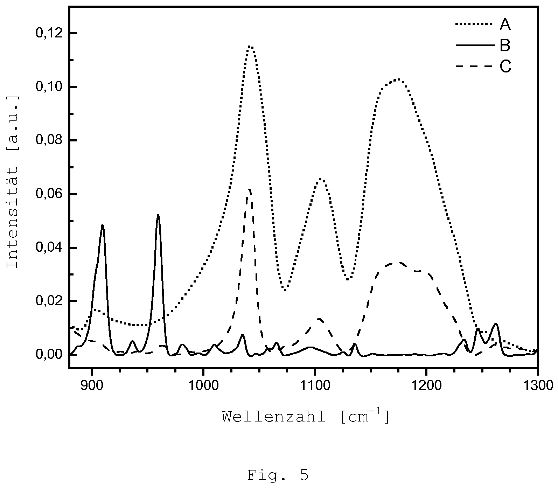

Figur 5 zeigt die IR-Spektren der Goldnanodrähte mit CTAB (AuNR@CTAB, B), dem reinen Liganden (A) und Goldnanodrähten mit erfindungsgemäßen Liganden (C). Bei den modifizierten Goldnanodrähten (C) sind die charakteristischen Banden des Liganden (A) zu erkennen. Diese fehlen bei den mit CTAB modifizierten Goldnanodrähten. Dies deutet darauf hin dass der Ligand auf der Oberfläche der Partikel adsorbiert ist.

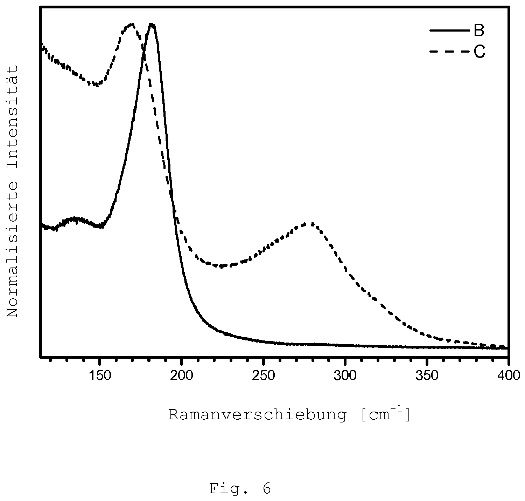

Figur 6 zeigt die Ramanspektren (785 nm Laser) der Goldnanodrähte mit CTAB (AuNR@CTAB, B) und Goldnanodrähten mit erfindungsgemäßen Liganden (C). Bei den erfindungsgemäß modifizierten Goldnanodrähten ist die Bande bei 278 cm⁻¹ einer Au-S-Bindung zu erkennen, während die Bande bei 182 cm⁻¹, typisch für eine Au-Br-Bindung, nicht zu erkennen ist. Dies zeigt, dass es zu einer Interaktion des Thiophen-Rückgrats mit der Oberfläche der Goldnanodrähte kommt. Kontrollexperimente mit Thiophen auf Goldoberflächen zeigten ein ähnliches Muster wie der Polythiophenligand.

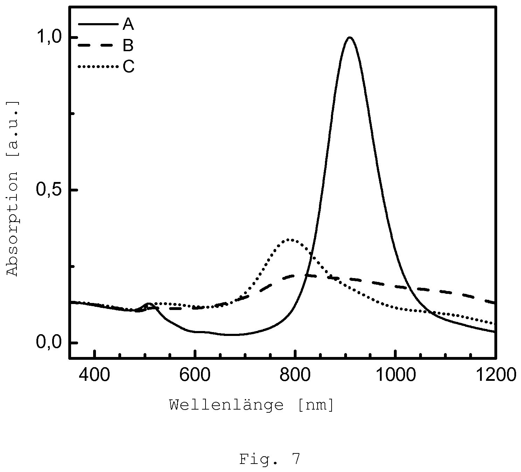

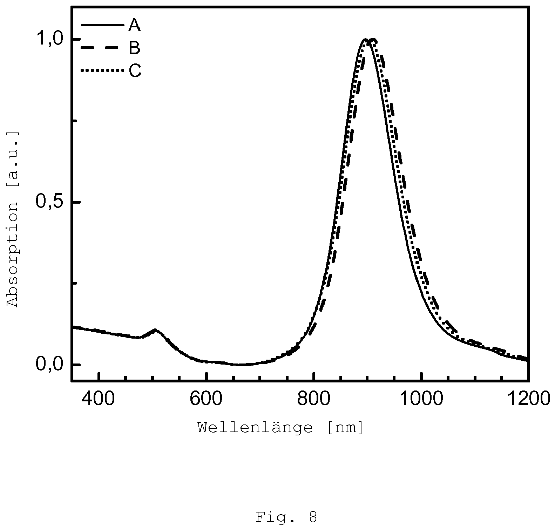

Die Figuren 7 und 8 zeigen die Stabilität der Dispersionen in unterschiedlichen Lösungsmitteln. Bei den Lösungsmitteln handelt es sich um reines Wasser (A), Methanol/Wasser (75/25, v/v) (B)und Aceton/Wasser (75/25, v/v). Während die Dispersionen mit erfindungsgemäßen Liganden in allen Fällen mindestens 6 Monate stabil waren und auch kaum eine Änderung in der Absorption zeigten, sind die mit CTAB modifizierten Goldnanodrähte nur in Wasser stabil. Schon kleine Mengen anderer Lösungsmittel führen zu einer Agglomeration und einer starken Veränderung des Absorptionsspektrums.

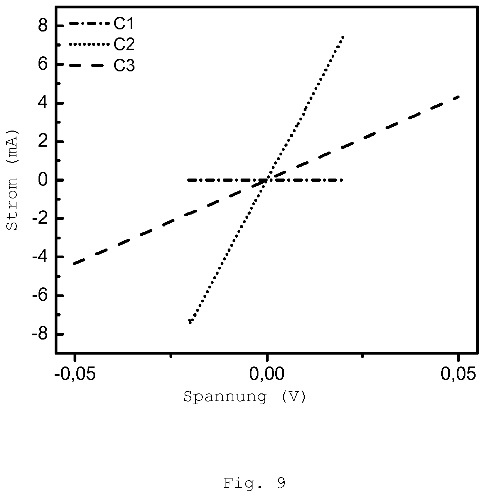

Figur 9 zeigt, Strom-Spannungsdiagramme für erhaltene Beschichtungen. Die Beschichtungen aus mit PEG-SH (25 kDa) modifizierten Goldnanodrähten zeigten keine Leitfähigkeit (C1). Wurden diese Beschichtungen für 30 Minuten mit einem Sauerstoffplasma behandelt, wurden sie leitfähig (C2). Ramanmessungen zeigen allerdings, dass dadurch auch der PEG-SH-Ligand entfernt wird, wodurch ein direkter Metall-Metall-Kontakt gebildet wird.

Die Schichten aus den Goldnanodrähten mit erfindungsgemäßen Liganden sind nach dem Trocknen direkt leitfähig ohne eine weitere Behandlung.

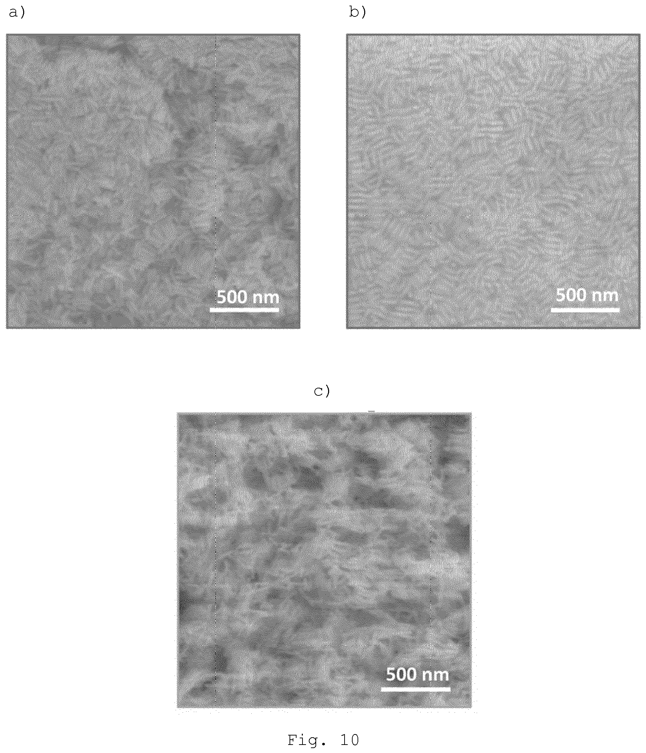

Figur 10 zeigt SEM-Aufnahmen von Oberflächen der verschieden modifizierten Goldnanodrähten.

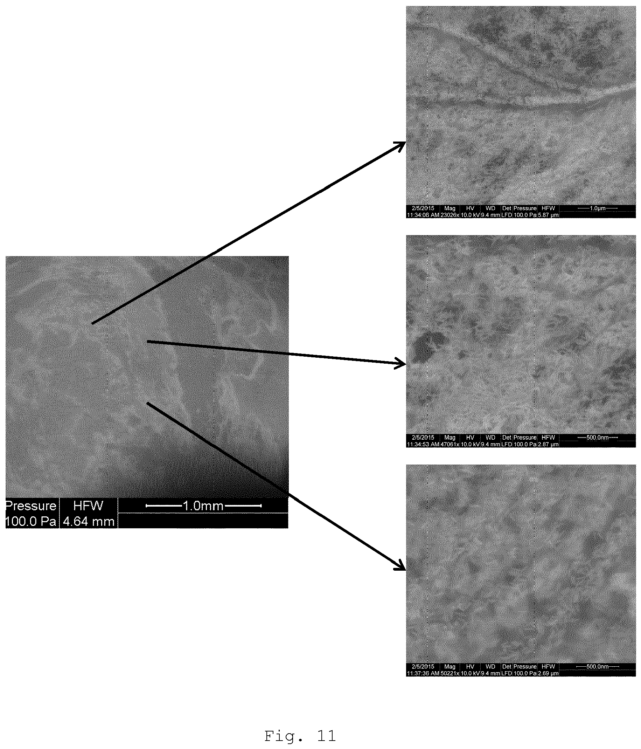

Figur 11 zeigt SEM Aufnahmen von einem leitfähigen Komposit Typ II (Es handelt sich um Goldnanorods mit leitfähigem Polymer als Liganden, eingebettet in eine PMMA Matrix, der Komposit wurde durch drop-casting einer Tinte dieser Komponenten in einem Lösemittelgemisch aus Aceton und Wasser 95,5/2,5 (v/v) erzeugt.

Das gezeigte Komposit ist leitfähig und zeigt einen Widerstand von 45 Ω.

Matrixpolymer kann z.B. als "Schutzschicht" oder als isolierende Schicht zwischen mehreren Leitfähigen schichten dienen. Auch wird die Nanostruktur das Partikeln durch das Matrixpolymer fixiert und ist damit mechanisch stabiler.

Es sind zahlreiche Abwandlungen und Weiterbildungen der beschriebenen Ausführungsbeispiele verwirklichbar.

### zitierte Literatur

Kanehara et al. Angew. Chem. Int. Ed. 2008, 47, 307-310;
Abe et al. Organic Electronics 2014, 15, 3465-3470;
Minari et al. Adv. Funct. Mater. 2014, 24, 4886-4892
US 2013/0001479 A1
US 2007/0057255 A1
Englebienne et al. J. Coll. Interface Sci. 2005, 292, 445-454; US 7,686,983
Ye et al. Nano Lett. 2013, 13, 765-771;
Liu et al. Nanoscale 2013, 5, 7936-7941;
Zhang et al. Adv. Mater. 2012, 24, 82-87;
Colle et al. Phys. Status Solidi B 2011, 248, 1360-1368.

## Patentansprüche

1. Zusammensetzung zur Herstellung von leitfähigen oder halbleitfähigen Schichten durch Nassbeschichten, umfassend
a) mindestens eine Art von leitfähigen oder halbleitfähigen Nanostrukturen, wobei auf der Oberfläche der Nanostrukturen mindestens ein leitfähiger Ligand angeordnet ist und die Nanostrukturen Nanodrähte mit einer Länge von unter 500 nm sind und der mindestens eine leitfähige Ligand ein Polymer oder Oligomer mit mindestens 10 Bindungsstellen aufweist, welche eine koordinative Bindung zur Oberflächen der Nanostruktur ermöglichen;
b) mindestens ein Lösungsmittel.

2. Zusammensetzung nach Anspruch 1, **dadurch gekennzeichnet, dass** der Ligand ein leitfähiges Polymer oder Oligomer auf der Basis von Thiophen ist.

3. Zusammensetzung nach einem der Ansprüche 1 oder 2, **dadurch gekennzeichnet, dass** die Nanostrukturen Nanodrähte sind mit einem Aspektverhältnis von Länge zu Durchmesser von mindestens 2:1.

4. Zusammensetzung nach einem der Ansprüche 1 bis 3, **dadurch gekennzeichnet, dass** die Zusammensetzung ein Matrixpolymer umfasst, welches gelöst in der Zusammensetzung vorliegt.

5. Zusammensetzung nach Anspruch 4, **dadurch gekennzeichnet, dass** das Matrixpolymer Polystyrol, Polyacrylat, Polyvinylalkohol und/oder Polyvinylpyrrolidon umfasst.

6. Zusammensetzung nach einem der Ansprüche 1 bis 5, **dadurch gekennzeichnet, dass** es sich um eine metallische Nanostruktur handelt.

7. Zusammensetzung nach einem der Ansprüche 1 bis 6 **dadurch gekennzeichnet, dass** das mindestens eine Lösungsmittel ausgewählt ist aus Lösungsmitteln oder Lösungsmittelgemischen aus Lösungsmitteln mit jeweils einem Siedepunkt von unter 120 °C.

8. Zusammensetzung nach einem der Ansprüche 1 bis 7, **dadurch gekennzeichnet, dass** der leitfähige Ligand in einer Konzentration von mindestens 0,5 µg Polymer je cm² Partikeloberfläche eingesetzt wird.

9. Zusammensetzung nach einem der Ansprüche 1 bis 8, **dadurch gekennzeichnet, dass** die Zusammensetzung mindestens 1 Monat stabil ist.

10. Verfahren zur Herstellung einer leitfähigen oder halbleitfähigen Schicht auf einer Oberfläche umfassend folgende Schritte:
a) Aufbringen einer Zusammensetzung nach einem der Ansprüche 1 bis 9 auf eine Oberfläche;
b) Entfernung des mindestens einen Lösungsmittels.

11. Verfahren nach Anspruch 10, **dadurch gekennzeichnet, dass** das Verfahren nach dem Auftragen auf die Oberfläche keine Behandlung der Beschichtung bei Temperaturen von über 60 °C umfasst.

12. Leitfähige oder halbleitfähige Struktur erhalten nach dem Verfahren nach einem der Ansprüche 10 oder 11.

13. Kompositmaterial umfassend eine leitfähige oder halbleitfähige Nanostruktur, mindestens einen leitfähigen Liganden und mindestens ein Matrixpolymer, wobei die Nanostrukturen Nanodrähte mit einer Länge von unter 500 nm sind und der mindestens eine leitfähige Ligand ein Polymer oder Oligomer mit mindestens 10 Bindungsstellen aufweist, welche eine koordinative Bindung zur Oberflächen der Nanostruktur ermöglichen.

14. Verwendung der Struktur nach Anspruch 12 oder des Kompositmaterials nach Anspruch 13 für Displays, Leiterbahnen, Schaltkreisen, Kondensatoren, und Solarzellen.

## Claims

1. A composition for producing conductive or semiconductive layers by wet coating, comprising
a) at least one type of conductive or semiconductive nanostructures, where at least one conductive ligand is arranged on the surface of the nanostructures, wherein the nanostructures are nanorods having a length of less than 500 nm and the at least one conductive ligand comprises a polymer or oligomer having at least ten bonding positions which make coordinate bonding to the surface of the nanostructure possible;
b) at least one solvent.

2. The composition as claimed in claim 1, **characterized in that** the ligand is a conductive polymer or oligomer based on thiophene.

3. The composition as claimed in either claim 1 or 2, **characterized in that** the nanostructures are nanorods having an aspect ratio of length to diameter of at least 2:1.

4. The composition as claimed in any of claims 1 to 3, **characterized in that** the composition comprises a matrix polymer, which is present as a solution in the composition.

5. The composition as claimed in claim 4, **characterized in that** the matrix polymer comprises polystyrene, polyacrylate, polyvinyl alcohol and/or polyvinylpyrrolidone.

6. The composition as claimed in any of claims 1 to 5, **characterized in that** the nanostructure is a metallic nanostructure.

7. The composition as claimed in any of claims 1 to 6, **characterized in that** the at least one solvent is selected from among solvents or solvent mixtures of solvents having in each case a boiling point below 120°C.

8. The composition as claimed in any of claims 1 to 7, **characterized in that** the conductive ligand is used in a concentration of at least 0.5 µg of polymer per cm² of particle surface.

9. The composition as claimed in any of claims 1 to 8, **characterized in that** the composition is stable for at least one month.

10. A process for producing a conductive or semiconductive layer on a surface, comprising the following steps:
a) application of a composition as claimed in any of claims 1 to 9 to a surface;
b) removal of the at least one solvent.

11. The process as claimed in claim 10, **characterized in that** the process does not comprise any treatment of the coating at temperatures above 60°C after application to the surface.

12. A conductive or semiconductive structure obtained by the process as claimed in either claim 10 or 11.

13. A composite material comprising a conductive or semiconductive nanostructure, at least one conductive ligand and at least one matrix polymer, wherein the nanostructures are nanorods having a length of less than 500 nm and the at least one conductive ligand comprises a polymer or oligomer having at least ten bonding positions which make coordinate bonding to the surface of the nanostructure possible.

14. The use of the structure as claimed in claim 12 or of the composite material as claimed in claim 13 for displays, conductor tracks, circuits, capacitors and solar cells.

## Revendications

1. Composition pour la préparation de couches conductrices ou semi-conductrices par enduit au mouillé, comprenant
a) au moins une sorte de nanostructures conductrices ou semi-conductrices, au moins un ligand conducteur étant disposé sur la surface des nanostructures et les nanostructures étant des nanofils comportant une longueur inférieure à 500 nm et l'au moins un ligand conducteur présentant un polymère ou un oligomère comportant au moins 10 sites de liaison, qui permettent une liaison coordinante à la surface de la nanostructure ;
b) au moins un solvant.

2. Composition selon la revendication 1, **caractérisée en ce que** le ligand est un polymère ou un oligomère conducteur à base de thiophène.

3. Composition selon l'une quelconque des revendications 1 et 2, **caractérisée en ce que** les nanostructures sont des nanofils comportant un rapport d'aspect de longueur à diamètre d'au moins 2:1.

4. Composition selon l'une quelconque des revendications 1 à 3, **caractérisée en ce que** la composition comprend un polymère matrice, qui est dissous dans la composition.

5. Composition selon la revendication 4, **caractérisée en ce que** le polymère matrice comprend du polystyrène, du polyacrylate, du poly(alcool vinylique) et/ou de la polyvinylpyrrolidone.

6. Composition selon l'une quelconque des revendications 1 à 5, **caractérisée en ce qu'elle** est une nanostructure métallique.

7. Composition selon l'une quelconque des revendications 1 à 6, **caractérisée en ce que** l'au moins un solvant est choisi parmi des solvants ou des mélanges de solvants parmi des solvants comportant à chaque fois un point d'ébullition inférieur à 120 °C.

8. Composition selon l'une quelconque des revendications 1 à 7, **caractérisée en ce que** le ligand conducteur est utilisé en une concentration d'au moins 0,5 µg de polymère par cm² de surface de particule.

9. Composition selon l'une quelconque des revendications 1 à 8, **caractérisée en ce que** la composition est stable au moins 1 mois.

10. Procédé pour la préparation d'une couche conductrice ou semi-conductrice sur une surface comprenant les étapes suivantes :
a) dépôt d'une composition selon l'une quelconque des revendications 1 à 9 sur une surface ;
b) élimination de l'au moins un solvant.

11. Procédé selon la revendication 10, **caractérisé en ce que** le procédé, après le dépôt sur la surface, ne comprend aucun traitement du revêtement à des températures supérieures à 60 °C.

12. Structure conductrice ou semi-conductrice obtenue par le procédé selon l'une quelconque des revendications 10 et 11.

13. Matériau composite comprenant une nanostructure conductrice ou semi-conductrice, au moins un ligand conducteur et au moins un polymère matrice, les nanostructures étant des nanofils comportant une longueur inférieure à 500 nm et l'au moins un ligand conducteur présentant un polymère ou un oligomère comportant au moins 10 sites de fixation, qui permettent une liaison coordinante à la surface de la nanostructure.

14. Utilisation de la structure selon la revendication 12 ou du matériau composite selon la revendication 13 pour des affichages, des pistes conductrices, des circuits, des condensateurs et des cellules solaires.
